# EUROPEAN PATENT SPECIFICATION

(11) **EP 1 713 061 B1**
(45) Date of publication and mention of the grant of the patent: **03.09.2008**
(21) Application number: 06252067.1
(22) Date of filing: 13.04.2006
(51) Int. Cl.: G10L 19/14, G10L 19/00, G10L 21/02

(54) **Apparatus and method of encoding audio data and apparatus and method of decoding encoded audio data**
Vorrichtung und Verfahren zur Kodierung von Audiodaten sowie Vorrichtung und Verfahren zur Dekodierung kodierter Audiodaten
Appareil et procédé d'encodage audio, appareil et procédé de décodage des données audio encodées

(30) Priority: 14.04.2005 US 671111 P; 12.08.2005 US 707546 P; 09.08.2005 US 706441 P; 30.12.2005 KR 20050135837
(43) Date of publication of application: 18.10.2006
(73) Proprietor: Samsung Electronics Co., Ltd., Suwon-si, Gyeonggi-Do (KR)
(72) Inventor: Kim, Miyoung, Gyeonggi-do (KR); Kim, Sangwook, Seoul (KR); Kim, Dohyung, Taean-eub,Hwaseong-si,Gyeonggi-do (KR); Lee, Shihwa, Gangnam-gu, Seoul (KR); Kim, Junghoe, Seoul (KR)
(74) Representative: Greene, Simon Kenneth

(56) References cited:
- WOLTERS M ET AL: "A CLOSER LOOK INTO MPEG-4 HIGH EFFICIENCY AAC" PREPRINTS OF PAPERS PRESENTED AT THE AES CONVENTION, XX, XX, vol. 115, 10 October 2003 (2003-10-10), XP008063876
- EHRER A ET AL: "Audio coding technology of ExAC" INTELLIGENT MULTIMEDIA, VIDEO AND SPEECH PROCESSING, 2004. PROCEEDINGS OF 2004 INTERNATIONAL SYMPOSIUM ON HONG KONG, CHINA OCT. 20-22, 2004, PISCATAWAY, NJ, USA,IEEE, 20 October 2004 (2004-10-20), pages 290-293, XP010801441 ISBN: 0-7803-8687-6
- HERRE J ET AL: "Overview of MPEG-4 audio and its applications in mobile communications" COMMUNICATION TECHNOLOGY PROCEEDINGS, 2000. WCC - ICCT 2000. INTERNATIONAL CONFERENCE ON BEIJING, CHINA 21-25 AUG. 2000, PISCATAWAY, NJ, USA,IEEE, US, vol. 1, 21 August 2000 (2000-08-21), pages 604-613, XP010526820 ISBN: 0-7803-6394-9
- PARK S-H ET AL: "MULTI-LAYER BIT-SLICED BIT-RATE SCALABLE AUDIO CODING" PREPRINTS OF PAPERS PRESENTED AT THE AES CONVENTION, vol. 103, September 1997 (1997-09), page 16, XP009016481

## Description

### BACKGROUND OF THE INVENTION

The present invention relates to the processing of audio data, and more particularly, to an apparatus and method of encoding audio data and an apparatus and method of decoding encoded audio data, in which the bitrate of encoded audio data can be adjusted, and even when the audio data included in a bitstream to be decoded is encoded audio data of some of the layers of the encoded audio data, the audio data of all of the layers can be recovered.

Bit sliced arithmetic coding (BSAC), which has been proposed by the applicant of the present invention, is a coding technique providing FGS(Fine Grain Scalability). In addition, BSAC is an audio compressing technique adopted as a standard by a moving picture experts group (MPEG)-4. BSAC is detailed in Korean Patent Publication No. 261253. Unlike BSAC, the advanced audio coding (AAC) technique does not provide FGS.

When an encoder that uses the AAC encodes audio data, it can encode only audio data in some of the frequency bands of the audio data and transmit the encoded audio data to a decoder.

In this case, a spectral band replication (SBR) technique may be considered to recover the audio data in all frequency bands from the audio data in only some of the frequency bands that have been encoded using the ACC. In other words, the encoder that uses the AAC produces and encodes SBR data having information about audio data in frequency bands other than the some frequency bands and transmits the SBR data to the decoder together with the encoded audio data in the some frequency bands. The decoder can recover the original audio data by inferring the audio data in the frequency bands other than the some encoded frequency bands. As such, the AAC and SBR techniques can be combined together.

An example of a system combining AAC and SBR is Wolters et al, "A closer look into MPEG-4 High Efficiency AAC" Audio Engineering Society EAS 115^{th} Convention, New York, October 2003.

Meanwhile, when an encoder that uses the BSAC encodes audio data, in contrast with the encoder that uses the AAC, the encoder that uses the BSAC can produce a base layer and at least one enhancement layer by dividing the audio data according to frequency bands, encode all of the layers of the audio data, and transmit only the audio data of some of the encoded layers that include the base layer to a decoder. Here, since the some layers are variable, the bit rate of the audio data encoded using the BSAC can be adjusted.

In contrast with the easy combination of the ACC and SBR techniques, the BSAC and SBR techniques are not combined well. That is, some of the encoded audio data layers to be transmitted to the decoder may vary case by case, and thus different SBR data should be produced for all possible cases.

This remains a demand for a scheme that is able to recover encoded audio data having layers using SBR data that is identical regardless of what some of the layers of the audio data to be transmitted to a decoder are.

### SUMMARY OF THE INVENTION

The present invention provides an audio data encoding apparatus for producing a bitstream that is made up of encoded spectral band replication (SBR) data and encoded audio data whose bitrate can be adjusted because the audio data is divided into a plurality of layers.

The present invention also provides an audio data decoding apparatus which decodes the audio data included in a to-be-decoded bitstream so as to recover audio data in the same frequency band as the frequency band of the audio data included in the bitstream and decodes the SBR data included in the bitstream, which is identical regardless of what the layers of the audio data included in the bitstream are, so as to recover audio data in a frequency band of frequencies greater than the maximum frequency of the audio data included in the bitstream.

The present invention provides an audio data encoding method of producing a bitstream that is made up of encoded spectral band replication (SBR) data and encoded audio data whose bitrate can be adjusted because the audio data is divided into a plurality of layers.

The present invention also provides an audio data decoding method of decoding the audio data included in a to-be-decoded bitstream so as to recover audio data in the same frequency band as the frequency band of the audio data included in the bitstream and decoding the SBR data included in the bitstream, which is identical regardless of what the layers of the audio data included in the bitstream are, so as to recover audio data in a frequency band of frequencies greater than the maximum frequency of the audio data included in,the bitstream.

The present invention provides a computer-readable recording medium which can store a computer program for producing a bitstream that is made up of encoded spectral band replication (SBR) data and encoded audio data whose bitrate can be adjusted because the audio data is divided into a plurality of layers.

The present invention also provides a computer-readable recording medium which can store a computer program for decoding the audio data included in a to-be-decoded bitstream so as to recover audio data in the same frequency band as the frequency band of the audio data included in the bitstream and decoding the SBR data included in the bitstream, which is identical regardless of what the layers of the audio data included in the bitstream are, so as to recover audio data in a frequency band of frequencies greater than the maximum frequency of the audio data included in the bitstream.

According to an aspect of the present invention, there is provided an audio data encoding apparatus according to claim 1.

According to another aspect of the present invention, there is provided an audio data decoding apparatus according to claim 14.

According to an aspect of the present invention, there is provided an audio data encoding method according to claim 27.

According to another aspect of the present invention, there is provided an audio decoding method according to claim 34.

According to an aspect of the present invention, there is provided a computer-readable storage medium according to claim 41.

According to another aspect of the present invention, there is provided a computer-readable storage medium according to claim 42.

### BRIEF DESCRIPTION OF THE DRAWINGS

The above and other features and advantages of the present invention will become more apparent by describing in detail exemplary embodiments thereof with reference to the attached drawings in which:
FIG. 1 is a block diagram of an audio-data encoding apparatus according to an embodiment of the present invention;
FIG. 2 is a graph used to explain audio data 200, which is an embodiment of the audio data in FIG. 1, the audio data 200 including a base layer and at least one enhancement layer;
FIG. 3 is a reference diagram to compare the frequency band of spectral band replication (SBR) data with the frequency bands of some layers transmitted to an audio-data decoding apparatus according to an embodiment of the present invention;
FIG. 4 illustrates a structure of an embodiment of a bitstream that is produced by the audio-data encoding apparatus of FIG. 1;
FIG. 5 is a block diagram of a scalable encoding unit 110A, which is an embodiment of a scalable encoding unit 110 shown in FIG. 1;
FIG. 6 illustrates a syntax of data that is encoded by the audio-data encoding apparatus of FIG. 1;
FIG. 7 illustrates a syntax of SBR data that is produced by the audio-data encoding apparatus of FIG. 1;
FIG. 8 is a block diagram of an audio-data decoding apparatus according to an embodiment of the present invention;
FIGs. 9A through 9D are graphs referred to explain the principle in which synthetic data is produced by the audio-data decoding apparatus of FIG. 1;
FIG. 10 is a block diagram of a scalable decoding unit 820A, which is an embodiment of a scalable decoding unit 820 shown in FIG. 8;
FIG. 11 is a block diagram of a SBR decoding unit 830A, which is an embodiment of a SBR decoding unit 830 shown in FIG. 8;
FIG. 12 is a block diagram of a data synthesis unit 840A, which is an embodiment of a data synthesis unit 840 shown in FIG. 8;
FIG. 13 is a flowchart illustrating an audio-data encoding method according to an embodiment of the present invention;
FIG. 14 is a flowchart illustrating an audio-data decoding method according to an embodiment of the present invention; and
FIG. 15 is a flowchart illustrating an operation 1430A, which is an embodiment of an operation 1430 shown in FIG. 14.

### DETAILED DESCRIPTION OF THE INVENTION

The attached drawings for illustrating preferred embodiments of the present invention are referred to in order to gain a sufficient understanding of the present invention, the merits thereof, and the objectives accomplished by the implementation of the present invention.

Hereinafter, the present invention will be described in detail by explaining preferred embodiments of the invention with reference to the attached drawings. Like reference numerals in the drawings denote like elements.

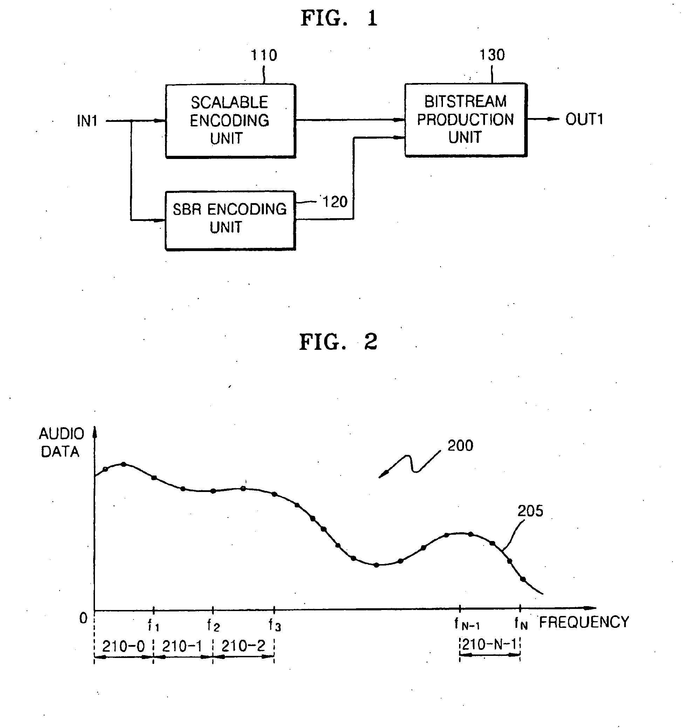

FIG. 1 is a block diagram of an audio-data encoding apparatus according to an embodiment of the present invention, which includes a scalable encoding unit 110, a spectral band replication (SBR) encoding unit 120, and a bitstream production unit 130. An operation of the audio-data encoding apparatus of FIG. 1 will now be described with reference to FIGs. 2 through 4.

The scalable encoding unit 110 encodes audio data received via an input port IN1 by dividing the received audio data into a plurality of layers, representing the layers in predetermined numbers of bits, and encoding the lower layers prior to the upper layers. When a layer is encoded, its upper bits are encoded prior to lower bits.

More specifically, the scalable encoding unit 110 converts the audio data in the time domain into audio data in the frequency domain. For example, the scalable encoding unit 110 may perform the conversion using a modified discrete cosine transform (MDCT) method.

Then, the scalable encoding unit 110 divides the frequency-domain audio data into the plurality of layers. The layers include a base layer and at least one enhancement layer. The layers are divided according to a frequency band. FIG. 2 is a graph referred to explain audio data 200, which is an embodiment of the audio data in FIG. 1. The audio data 200 includes a base layer 210-0 and a plurality of enhancement layers 210-1, 210-2, ... , and 210-N-1. As shown in FIG. 2, the layers 210-0, 210-1, 210-2, ... , and 210-N-1 are N (where N denotes an integer equal to or greater than 2) layers. The enhancement layers 210-1, 210-2, ... , and 210-N-1 are referred to as first, second, ... , and (N-1)th enhancement layers, respectively. The frequency band of the audio data 200 is 0 to f_{N} [kHz]. Reference numeral 205 denotes an envelope that is represented by the audio data 200. Consequently, the lowest layer is the bas layer 210-0, and the highest layer is the (N-1)th enhancement layer 210-N-1.

The scalable encoding unit 110 quantizes the divided audio data. In the embodiment of FIG. 2, the scalable encoding unit 110 quantizes the divided audio data 200 indicated by dots.

The scalable encoding unit 110 represents the quantized divided audio data in a predetermined number of bits. Different numbers of bits may be allocated according to the type of a layer.

The scalable encoding unit 110 hierarchically encodes the quantized audio data. For example, the scalable encoding unit 110 may encode the quantized audio data using bit sliced arithmetic coding (BSAC).

Audio data transmitted to an audio-data decoding apparatus according to an embodiment of the present invention may be the entire audio data, namely, audio data of all of the layers, or partial audio data, namely, audio data of some of the layers. Here, the some layers transmitted to the audio data decoding apparatus denote at least one layer including the base layer 210-0. As such, when some of the layers of the audio data are transmitted to the audio-data decoding apparatus, the audio data corresponding to the some layers is desirably encoded earlier than the audio data corresponding to the other residual layers.

To achieve this, the scalable encoding unit 110 encodes the quantized audio data in such a way that the lower layers are encoded earlier than the upper layers and the upper bits of each layer are encoded earlier than the lower bits thereof. Hence, the scalable encoding unit 110 encodes the audio data of the lowest layer 210-0 at the very first and encodes the audio data of the highest layer 210-N-1 at the very last. Furthermore, when the scalable encoding unit 110 encodes the audio data of each layer, it encodes at least one most significant bit (MSB) among the audio data at the very first and at least one least significant bit (LSB) at the very last. This encoding sequence is derived from the fact that significant information included in audio data is generally more distributed in lower layers than upper layers and furthermore more in the upper bits of each layer than the lower bits thereof.

In this way, the scalable encoding unit 110 encodes all of the layers of the audio data.

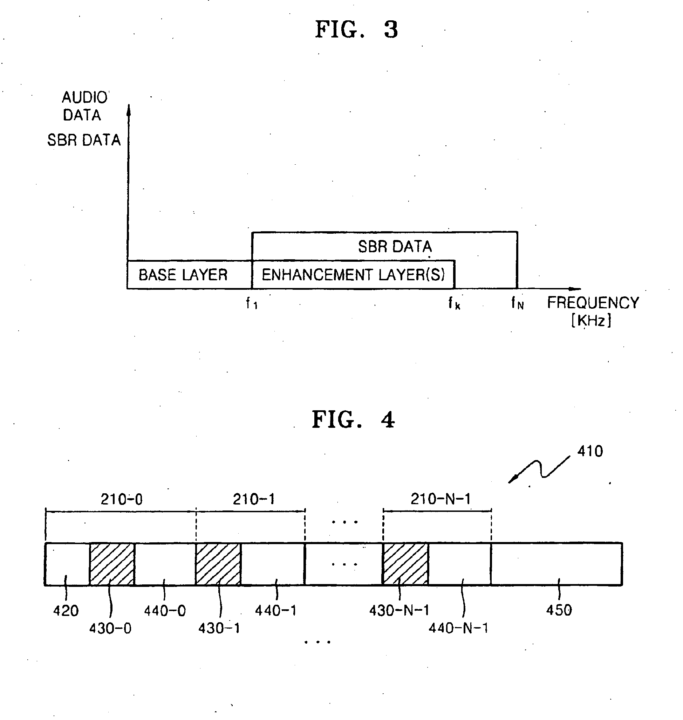

The SBR encoding unit 120 produces SBR data and encodes the same. The SBR data according to the present invention, denotes data including information about audio data in a frequency band between a first frequency and a second frequency. The first frequency may be a frequency equal to or greater than the maximum frequency f₁ of the base layer 210-0. The first frequency is preferably the maximum frequency f₁. the second frequency may be preferably, a frequency equal to or greater than the maximum frequency fₖ of the highest layer among the some layers that are transmitted to the audio-data decoding apparatus, more preferably, the maximum frequency f_{N} of the encoded audio data of all layers. FIG. 3 is a reference diagram to compare the frequency band f₁- f_{N} of the SBR data with the frequency band 0- fₖ of the some layers transmitted to the audio-data decoding apparatus according to an embodiment of the present invention. In FIG. 3, k denotes an integer in between 2 and N. However, when only the base layer 210-0 is transmitted to the audio-data decoding apparatus, k is 1.

The information about the audio data may denote information about noise of the audio data or information about the envelope 205 of the audio data.

More specifically, the SBR encoding unit 120 may produce SBR data using the information about the envelope 205 of the audio data in the frequency band between the first and second frequencies and perform lossless encoding on the produced SBR data. Herein, the lossless encoding is entropy encoding or Huffman encoding.

The bitstream production unit 130 produces a bitstream using the Huffman-encoded SBR data and audio data corresponds to a predetermined bitrate among the encoded audio data of all of the layers, and outputs the bitstream via an output port OUT1. FIG. 4 illustrates a structure of a bitstream 410, which is an embodiment of the bitstream produced by the audio-data encoding apparatus of FIG. 1. As shown in FIG. 4, the bitstream 410 includes a header 420, information 430-0 about the number of bits in which the audio data of the base layer 210-0 is represented, information 440-0 about the encoded audio data of the base layer 210-0 and the step size of quantization on the base layer 210-0, information 430-n, information 440-n, and SSR data 450. The information 430-n indicates the number of bits in which the audio data of an n-th enhancement layer 210-n (where n is an integer satisfying 1 ≤ n ≤ N-1) is represented. The information 440-n indicates the encoded audio data of the n-th enhancement layer 210-n and the step size of quantization on the n-th enhancement layer 210-n. As shown in FIG. 4, the encoded audio data 430-0, 430-1, ... , and 430-N-1 of the bitstream 410 are allocated for the respective layers 210-0, 210-1, ... , and 210-N-1. However, the encoded SBR data 450 included in the bitstream 410 is not allocated for each of the layers.

The predetermined bitrate denotes the bitrate of the audio data of the some layers to be transmitted to the audio-data decoding apparatus among the audio data included in all the encoded layers. In other words, the predetermined bitrate is equal to or greater than the bitrate of the base layer 210-0.

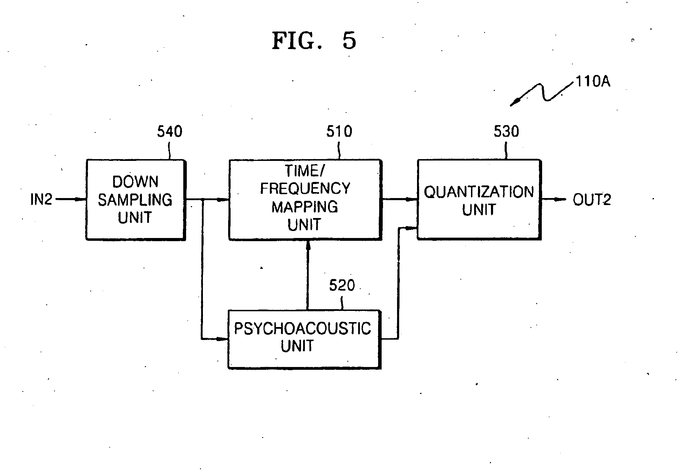

FIG. 5 is a block diagram of a scalable encoding unit 110A, which is an embodiment of the scalable encoding unit 110 shown in FIG. 1. The scalable encoding unit 110A includes a time/frequency mapping unit 510, a psychoacoustic unit 520, a quantization unit 530, and a down sampling unit 540.

The time/frequency mapping unit 510 converts audio data in the time domain received via an input port IN2 into audio data in the frequency domain. The input port IN2 may be the same as the input port IN1. Frequency of the audio data in the time domain is a predetermined sampling frequency Fs. In addition, the audio data in the time domain is a discrete audio data.

The psychoacoustic unit 520 groups the audio data output by the time/frequency mapping unit 510 according to a frequency band so as to produce a plurality of layers.

The quantization unit 530 quantizes audio data of each of the layers and encodes the quantized audio data of all of the layers in such a way that the lower layers are encoded prior to the upper layers and the upper bits of each layer are encoded prior to the lower bits thereof. The quantization unit 530 outputs the result of the encoding to the bitstream production unit 130 via an output port OUT2.

The down sampling unit 540 is optional. The down sampling unit 540 samples the audio data in the time domain at a sampling frequency less than the predetermined sampling frequency Fs, that is, at Fs/2, and outputs the result of the sampling to the time/frequency mapping unit 510 and the psychoacoustic unit 520.

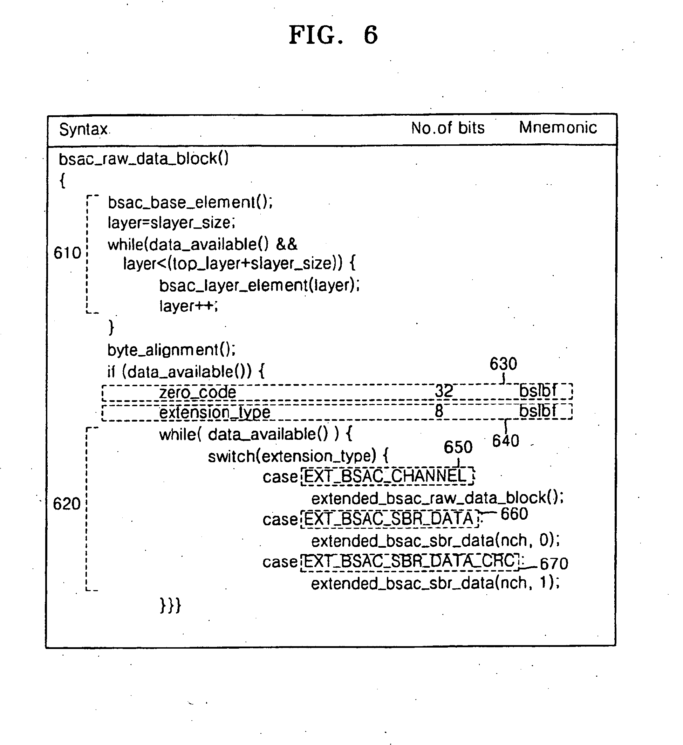

FIG. 6 illustrates a syntax of the audio data that is encoded by the audio-data encoding apparatus of FIG. 1. Reference numeral 610 denotes audio data encoded according to the BSAC technique, and reference numeral 620 denotes data that can be combined with the audio data 610. The data 620 includes multi-channel extended data EXT_BSAC_CHANNEL 650, spectral band replication data EXT_BSAC_SBR_DATA 660, and 'error detection data and SBR data' EXT_BSAC_SBR_DATA_CRE 670.

The multi-channel extended data EXT_BSAC_CHANNEL 650 denotes audio data of third through M-th (where M denotes an integer equal to or greater than 3) channels. When the audio data given to the audio-data encoding apparatus of FIG. 1 is audio data given via 3 or more channels, the third through M-th channels denote the channels other than a mono channel (i.e., a first channel) and a stereo channel (i.e., first and second channels). As such, if audio data is given via three or more channels, the scalable encoding unit 110 may include a mono/stereo encoding unit (not shown) and a multi-channel extended data encoding unit (not shown). The mono/stereo encoding unit encodes audio data of the first or second channel. The multi-channel extended encoding unit encodes audio data of each of the third through M-th channels. The error detection data denotes data that is used in detecting an error from the spectral band replication data EXT_BSAC_SBR_DATA 660. Moreover, EXT_BSAC_SBR_DATA_CRE 670 denotes the error detection data and the SBR data.

The audio data being encoded by the audio-data encoding apparatus may further include starting codes 630 and 640, indicating the start of the combinable data 620, in addition to the audio data 610 and the combinable data 620. The starting code 630 and 640 may be one of a first starting code, a second starting code, and a third starting code.

The first starting code indicates the start of the SBR data EXT_BSAC_SBR_DATA 660. More specifically, the first starting code may include a zero code zero_code 630 represented in 32 bits of 0 and an extension code extension_type 640 represented in '1111 0000'. The SBR encoding unit may include a first starting code encoding unit (not shown) for encoding the first starting code.

The second starting code indicates the start of the error detection data and the SBR data EXT_BSAC_SBR_DATA_CRE 670. More specifically, the second starting code may include the zero code zero_code 630, which is represented in 32 bits of 0, and an extension code extension_type 640 represented in '1111 0001'. The SBR encoding unit may include a second starting code encoding unit (not shown) for encoding the second starting code.

The third starting code indicates the start of the audio data of the third through M-th channels. More specifically, the third starting code may include the zero code zero_code 630, which is represented in 32 bits of 0, and an extension code extension_type 640 represented in '1111 1111'. The multi-channel extended data encoding unit may include a third starting code encoding unit (not shown) for encoding the third starting code.

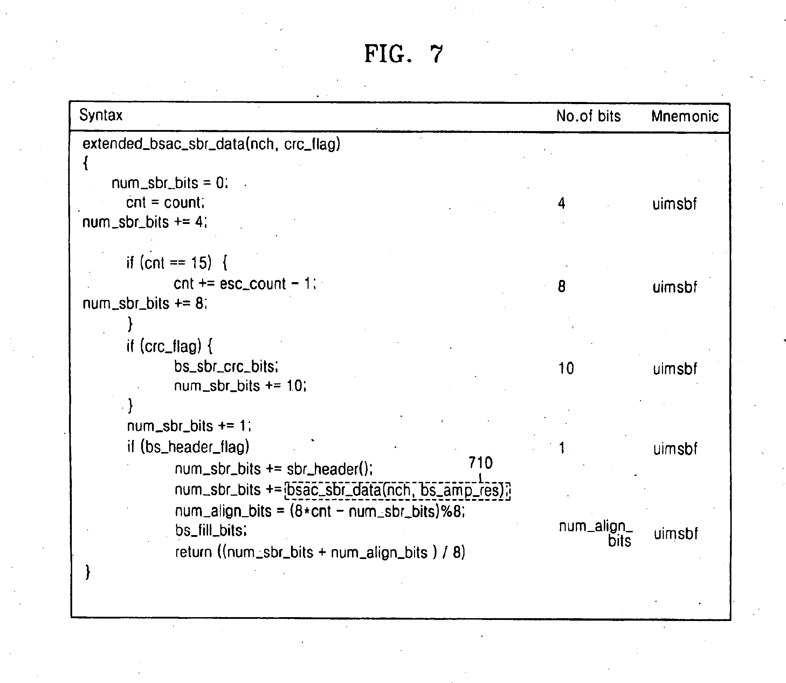

FIG. 7 illustrates a syntax of the SBR data that is produced by the audio-data encoding apparatus of FIG. 1. The audio data to be encoded by the audio-data encoding apparatus of FIG. 1 may be given through the first channel or the second channel. Data bsac_sbr_data(nch, bs_amp_res) 710 indicates that the SBR encoding unit 120 encodes SBR data for each of the channels.

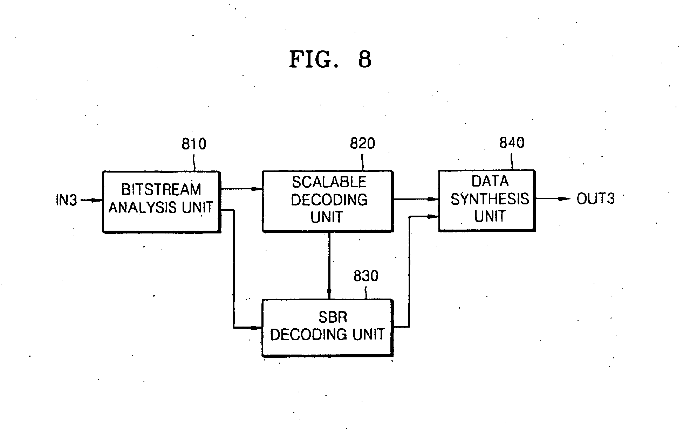

FIG. 8 is a block diagram of the audio-data decoding apparatus according to an embodiment of the present invention, which includes a bitstream analysis unit 810, a scalable decoding unit 820, an SBR decoding unit 830, and a data synthesis unit 840. The bitstream analysis unit 810 extracts 'encoded SBR data' and 'encoded audio data having at least one layer, each of the layers being expressed in a predetermined number of bits' from a bitstream received via an input port IN3. The bitstream may be the bitstream output via the output port OUT1. In other words, the bitstream analysis unit 810 extracts 'the SBR data produced by the SBR encoding unit 120' and 'the audio data corresponding to at least one layer among the entire audio data of all of the layers that are produced by the scalable encoding unit 110' from the bitstream received via the input port IN3.

The scalable decoding unit 820 decodes the extracted audio data by decoding the audio data of lower layers earlier than the audio data of upper layers and the upper bits of each layer earlier than the lower bits thereof. The decoding of the extracted audio data by the scalable decoding unit 820 may be performed at or below the predetermined bitrate. For example, when the audio data included in the bitstream produced by the bitstream production unit 130 among the audio data encoded by the scalable encoding unit 110 are the audio data of the base layer 210-0 and the first and second enhancement layers 210-1 and 210-2, the scalable decoding unit 820 may decode all of the audio data of the base layer 210-0 and the first and second enhancement layers 210-1 and 210-2, or only the audio data of the base layer 210-0 and the first enhancement layer 210-1, or only the audio data of the base layer 210-0. The predetermine bitrate may be equal to or greater than the bitrate of the base layer 210-0.

In case that encoded audio data is included in the received bitstream for each of the first through M-th channels, the scalable decoding unit 820 may include a mono/stereo decoding unit (not shown), a multi-channel extended data decoding unit (not shown), and a third starting code decoding unit (not shown). The mono/stereo decoding unit decodes the encoded audio data of the first or second channel. The multi-channel extended data decoding unit decodes the encoded audio data of each of the third through M-th channels. The third starting code decoding unit decodes the encoded third starting code. As such, when the scalable decoding unit 820 includes the multi-channel extended data decoding unit, the bitstream analysis unit 810 checks if the encoded third starting code is included in the received bitstream. When it is checked that the encoded third starting code is included in the received bitstream, the bitstream analysis unit 810 extracts the encoded third starting code from the received bitstream, and the third starting code decoding unit decodes the extracted third starting code and directs the multi-channel extended data decoding unit to operate.

The SBR decoding unit 830 decodes the extracted SBR data. And the SBR decoding unit 830 infers the audio data in the frequency band between the first and second frequencies based on the audio data received from the scalable decoding unit 820 and the decoded SBR data.

The audio data decoding apparatus may include a first starting code decoding unit (not shown) and a second starting code decoding unit (not shown). In this case, the bitstream analysis unit 810 checks if the encoded first and second starting codes are included in the received bitstream. When it is checked that the encoded first and second starting codes are included in the received bitstream, the bitstream analysis unit 810 extracts the encoded first and second starting codes from the received bitstream, and the first and second starting code decoding units decodes the extracted first and second starting codes, respectively. Then, the first and second starting code decoding units direct the SBR decoding unit 830 to operate.

The data synthesis unit 840 produces synthetic data from the audio data received from the scalable decoding unit 820 and the audio data inferred by the SBR decoding unit 830. The data synthesis unit 840 also converts the synthetic data, which is data in the frequency domain, into synthetic data in the time domain and outputs the synthetic data in the time domain as the audio data in the frequency band ranging from 0 to the second frequency via an output port OUT3. In other words, when the maximum frequency of the entire audio data encoded by the audio data encoding apparatus is the second frequency, although the audio data included in the bitstream is only the audio data of some of the layers, the data synthesis unit 840 recovers the audio data of all of the layers.

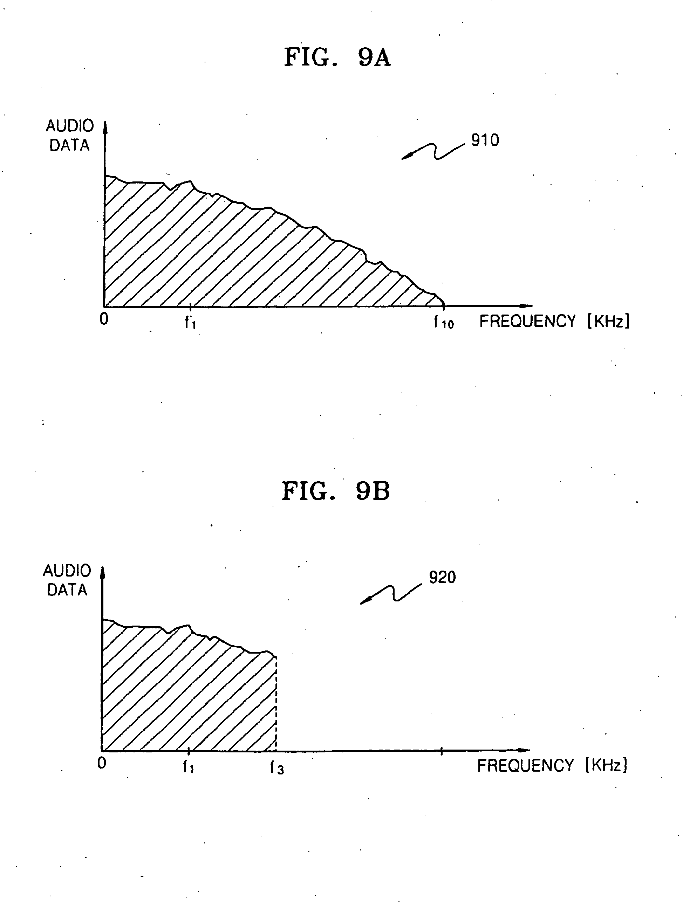

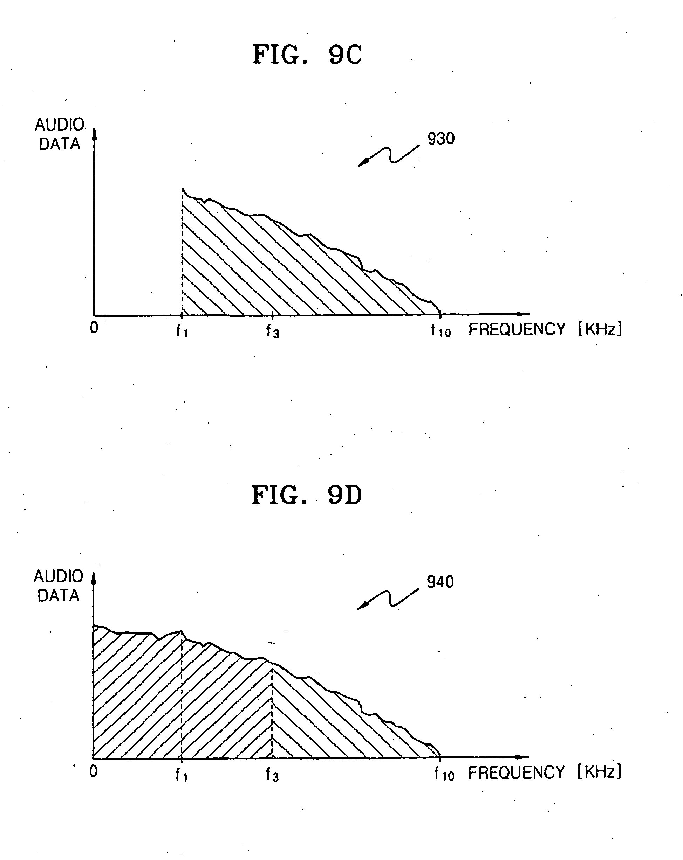

FIGs. 9A through 9D are graphs referred to explain the operation of the data synthesis unit 840 in greater detail. FIG. 9A illustrates audio data 910 input to the scalable encoding unit 110, FIG. 9B illustrates audio data 920 decoded by the scalable decoding unit 820, FIG. 9C illustrates audio data 930 inferred by the SBR decoding unit 830, and FIG. 9D illustrates synthetic data 940 produced by the data synthesis unit 840, that is, a result of the reconstructing of the audio data in a frequency band between zero and a second frequency.

For convenience of explanation, it is illustrated in FIGs. 9A through 9D that the audio data 910, 920, 930, and 940 are continuous data. However, actually, the audio data 910, 920, 930, and 940 are discrete data.

As shown in FIG. 9A, the audio data 910 input to the scalable encoding unit 110 exists in a frequency band from 0 to f₁₀ kHz. The audio data 920 decoded by the scalable decoding unit 820 exists in a frequency band from 0 to f₃ kHz. The bitstream may include the encoded audio data of all the layers or the audio data of some of the layers. In FIG. 9B, the bitstream includes only the audio data of some of the layers, that is, only the audio data in the frequency band from 0 to f₃ kHz. It is desirable that the some layers always include the base layer in the frequency band from 0 to f₁ kHz.

The audio data 930 inferred by the SBR decoding unit 830 exists in a frequency band from f₁ to f₁₀ kHz. The synthetic data 940 produced by the data synthesis unit 840 exists in a frequency band from 0 to f₁₀ kHz. In other words, the synthetic data 940 is the result of decoding of the audio data 910. The audio data 940 and 910 may be different to some degree but are desirably identical with each other.

The data synthesis unit 840 outputs the decoded audio data 920 as synthetic data for the frequency band (i.e., from 0 to f₃ kHz) where the decoded audio data 920 exists.

The data synthesis unit 840 outputs the inferred audio data 930 as synthetic data for the frequency band (i.e., from f₃ to f₁₀ kHz) where the decoded audio data 920 does not exist.

As a result, the data synthesis unit 840 determines the decoded audio data 920 to be synthetic data for the frequency band (i.e., from f₁ to f₃ kHz) where both the decoded audio data 920 and the inferred audio data 930 exist.

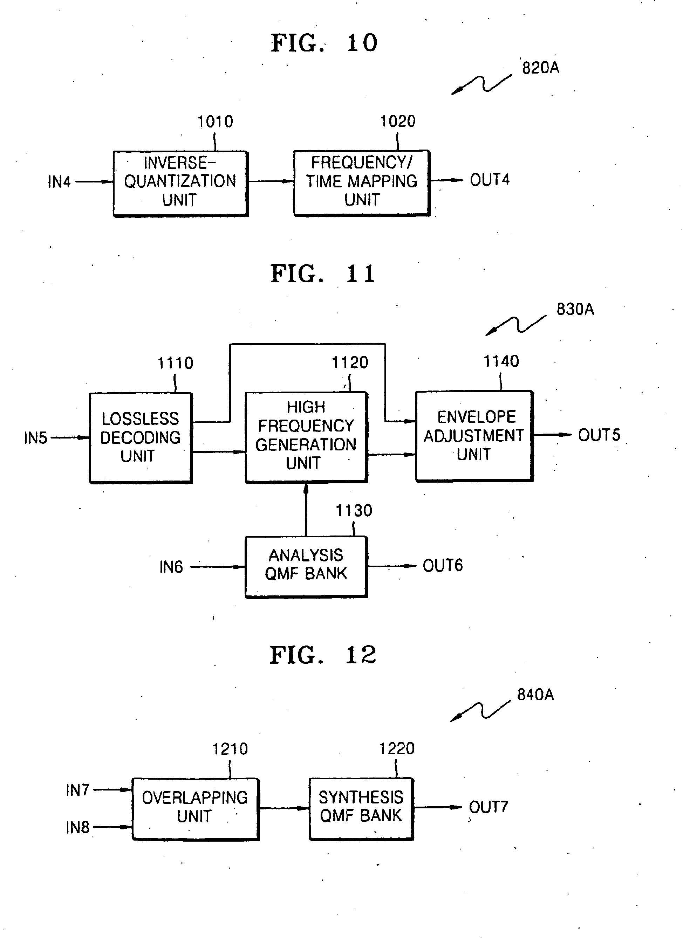

FIG. 10 is a block diagram of a scalable decoding unit 820A, which is an embodiment of the scalable decoding unit 820 shown in FIG. 8. The scalable decoding unit 820A includes an inverse-quantization unit 1010 and a frequency/time mapping unit 1020.

The inverse-quantization unit 1010 receives 'the exacted audio data' via an input port IN4, decodes the received audio data, and inversely quantizes the decoded audio data. The frequency/time mapping unit 1020 converts the inversely quantized audio data in the frequency domain into audio data in the time domain and outputs the audio data in the time domain via an output port OUT4.

FIG. 11 is a block diagram of a SBR decoding unit 830A, which is an embodiment of the SBR decoding unit 830 shown in FIG. 8. The SBR decoding unit 830A includes a lossless decoding unit 1110, a high frequency generation unit 1120, an analysis QMF bank 1130, and an envelope adjustment unit 1140.

The lossless decoding unit 1110 receives 'the extracted SBR data' via an input port IN5 and performs lossless decoding on the received SBR data. Herein, the lossless decoding is entropy decoding or Huffman decoding. Hence, the lossless decoding unit 1110 obtains information about audio data in the frequency band between the first and second frequencies from the extracted SBR data. For example, the lossless decoding unit 1110 obtains information about the envelope of the audio data in the frequency band between the first and second frequencies.

The high frequency generation unit 1120 causes the decoded audio data 920 to be generated in frequency bands (in FIG. 9, f₃-f₆, f₆-f₉, and f₉-f₁₀) that are equal to or greater than the maximum frequency f₃ (see FIG. 9) of the audio data 920. To achieve the generation of the audio data 920 in the frequency bands, since the decoded audio data 920 is audio data in the time domain, the high frequency generation unit 1120 may convert the encoded audio data into audio data in the frequency domain. To achieve this conversion, the SBR decoding unit 830 may include the analysis QMF bank 1130 as the SBR decoding unit 830A does.

The analysis QMF bank 1130 converts 'the decoded audio data' received via an input port IN6 into audio data in the frequency domain and outputs the audio data in the frequency domain via an output port OUT6.

The envelope adjustment unit 1140 adjusts the envelope of the audio data generated by the high frequency generation unit 1120, using the information obtained by the lossless decoding unit 1110. That is, the envelope adjustment unit 1140 adjusts the audio data generated by the high frequency generation unit 1120 so that the envelope of the audio data is identical to that of the audio data encoded by the scalable encoding unit 110. The adjusted audio data is output via an output port OUT5. The audio data input to the scalable encoding unit 110, which exists in the frequency band between the first and second frequencies, is inferred as the adjusted audio data.

FIG. 12 is a block diagram of a data synthesis unit 840A, which is an embodiment of the data synthesis unit 840 shown in FIG. 8. The data synthesis unit 840A includes an overlapping unit 1210 and a synthesis QMF bank 1220.

The overlapping unit 1210 receives 'the audio data 920 decoded by the scalable decoding unit 820' via an input port IN7 and 'the audio data 930 inferred by the SBR decoding unit 830' via an input port IN8 and produces synthetic data using the decoded audio data 920 and the inferred audio data 930.

More specifically, the overlapping unit 1210 outputs the decoded audio data 920 as the synthetic data for the frequency band (i.e., from 0 to f₃ kHz in FIG. 9) where the decoded audio data 920 exists. The overlapping unit 1210 outputs the inferred audio data 930 as the synthetic data for the frequency band (see from f₃ to f₁₀ kHz in FIG. 9) where only the inferred audio data 930 exists.

The decoded audio data 920 received via the input port IN7 and the inferred audio data 930 received via the input port IN8 are both audio data in the frequency domain. Accordingly, if the decoded audio data is audio data in the time domain, it is desirably input to the input port IN7 via the analysis QMF bank 1130.

The synthesis QMF bank 1220 converts the synthetic data in the frequency domain into synthetic data in the time domain and outputs the synthetic data in the time domain via an output port OUT7.

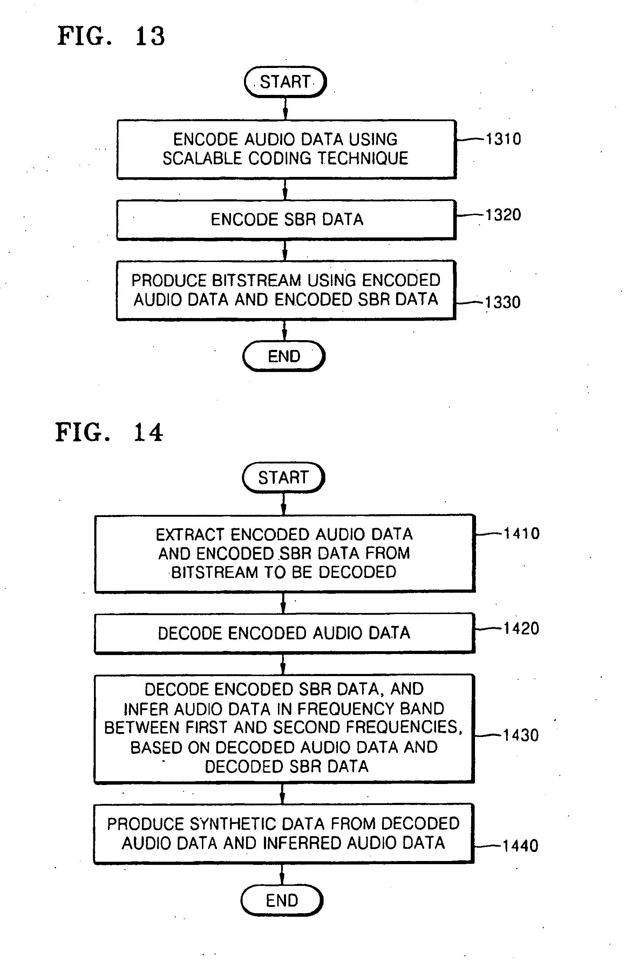

FIG. 13 is a flowchart illustrating an audio-data encoding method according to an embodiment of the present invention performed by the audio-data encoding apparatus of FIG. 1. The audio-data encoding method includes operation 1310 through 1330 of encoding audio data using the BASC technique, encoding SBR data, and producing a bitstream using the encoded audio data and the encoded SBR data.

In operation 1310, the scalable encoding unit 110 divides the received audio data into a plurality of layers, represents the layers of the audio data in predetermined numbers of bits, and encodes the lower layers earlier than the upper layers and the upper bits of each layer earlier than the lower bits thereof.

In operation 1320, the SBR encoding unit 120 produces SBR data having the information about the audio data in the frequency band ranging from the first frequency to the second frequency and performs Huffman coding on the SBR data.

The operation 1320 may be performed after the operation 1310 as shown in FIG. 13. Alternatively, in contrast with FIG. 13, the operation 1320 may be performed before or at the same time as the operation 1310.

After operations 1310 and 1320, in operation 1330, the bitstream production unit 130 produces a bitstream using the audio data encoded in operation 1310 and the SBR data encoded in operation 1320.

FIG. 14 is a flowchart illustrating an audio-data decoding method according to an embodiment of the present invention performed by the audio-data decoding apparatus of FIG. 8. The audio-data decoding method includes operations 1410 through 1440 of decoding the audio data included in a to-be-decoded bitstream so as to recover the audio data in the same frequency band as the frequency band of the audio data included in the bitstream and decoding the SBR data included in the bitstream, which is identical regardless of what the layers of the audio data included in the bitstream are, so as to recover audio data in a frequency band of frequencies equal to or greater than the maximum frequency of the audio data included in the bitstream.

In operation 1410, the bitstream analysis unit 810 extracts the audio data encoded in operation 1310 and the SBR data encoded in operation 1320 from the bitstream to be decoded.

In operation 1420, the scalable decoding unit 820 decodes the audio data encoded in operation 1310 by decoding lower layers earlier than upper layers and the upper bits of each layer earlier than the lower bits thereof.

In operation 1430, the SBR decoding unit 830 decodes the SBR data encoded in operation 1320, and infers the audio data in the frequency band between the first and second frequencies, based on the audio data decoded in operation 1420 and the decoded SBR data.

In operation 1440, the data synthesis unit 840 produces synthetic data from the audio data decoded in operation 1420 and the audio data inferred in operation 1430 and determines the synthetic data as the audio data in the frequency band between 0 and the second frequency.

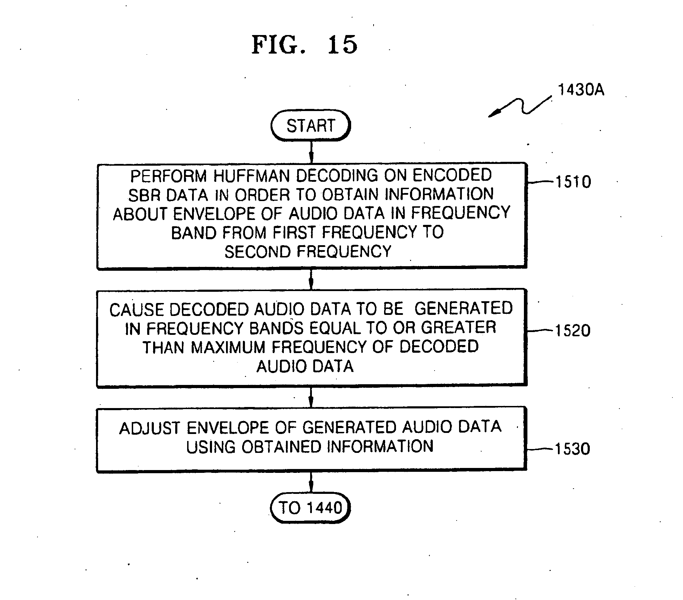

FIG. 15 is a flowchart illustrating operation 1430A, which is an embodiment of the operation 1430. The operation 1430A includes operations 1510 through 1530 of inferring the audio data in the frequency band between the first and second frequencies based on the audio data decoded in operation 1420 and the SBR data encoded in operation 1320.

In operation 1510, the lossless decoding unit 1110 performs lossless decoding on the encoded SBR data included in the to-be-decoded bitstream in order to obtain information about the envelope of the audio data in the frequency band from the first frequency to the second frequency.

In operation 1520, the high frequency generation unit 1120 causes the audio data decoded in operation 1420 to be generated in the frequency bands equal to or greater than the maximum frequency of the decoded audio data.

In operation 1530, the envelope adjustment unit 1140 adjusts the envelope of the audio data generated in operation 1520 using the information obtained in operation 1510. The operation 1530 is followed by operation 1440.

As described above, in an apparatus and method of encoding audio data and an apparatus and method of decoding encoded audio data according to the present invention, the audio data included in a to-be-decoded bitstream is decoded so as to recover the audio data in the same frequency band as the frequency band of the audio data included in the bitstream, and the SBR data included in the bitstream is decoded so as to recover audio data in a frequency band of frequencies equal to or greater than the maximum frequency of the audio data included in the bitstream. Hence, even when the audio data included in the bitstream is the encoded audio data of some of the layers, the audio data of all the layers is recovered. Furthermore, the SBR data included in the bitstream is fixed regardless of what the layers of the audio data included in the bitstream are, so that the BSAC and SBR techniques can be easily combined together.

Embodiments of the invention can also be embodied as computer readable codes on a computer readable recording medium. The computer readable recording medium is any data storage device that can store data which can be thereafter read by a computer system. Examples of the computer readable recording medium include read-only memory (ROM), random-access memory (RAM), CD-ROMs, magnetic tapes, floppy disks, optical data storage devices, and carrier waves (such as data transmission through the Internet). The computer readable recording medium can also be distributed over network coupled computer systems so that the computer readable code is stored and executed in a distributed fashion.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. An audio data encoding apparatus for encoding audio data comprising:
a scalable encoding unit (110) arranged to divide the audio data into a plurality of layers, to represent the audio data in predetermined numbers of bits every layer, and to encode the lower layer earlier than the upper layer and the upper bit of each layer earlier than the lower bit thereof;
an SBR encoding unit (120) arranged to produce SBR (spectral band replication) data that has information about the audio data in a band of frequencies between a first predetermined frequency and a second predetermined frequency among the audio data to be encoded, and to encode the SBR data; and
a bitstream production unit (130) arranged to produce a bitstream using the encoded SBR data and the encoded audio data corresponding to a predetermined bitrate;
wherein the second predetermined frequency is equal to or greater than the maximum frequency of the layers, and the SBR data comprises information about the audio data in the frequency band between the first and the second frequencies.

2. The audio data encoding apparatus of claim 1, wherein the first predetermined frequency is the maximum frequency of the lowest layer of the layers of the audio data.

3. The audio data encoding apparatus of claim 1 or 2, wherein the SBR encoding unit (120) is arranged to produce the SBR data using information about the envelope of the audio data having the frequency band of frequencies equal to or greater than a predetermine frequency and performs lossless encoding on the produced SBR data.

4. The audio data encoding apparatus of claim 3, wherein the lossless encoding is entropy encoding or Huffman encoding.

5. The audio data encoding apparatus of any preceding claim, wherein the scalable encoding unit (110) is arranged to down sample the audio data and to divide the down-sampled audio data to produce the plurality of layers.

6. The audio data encoding apparatus of claim 1, wherein the predetermined bitrate is equal to or greater than the bitrate of the lowest layer.

7. The audio data encoding apparatus of any preceding claim, wherein the SBR encoding unit (120) further comprises a first starting code encoding unit arranged to encode a first starting code that indicates the start of the SBR data.

8. The audio data encoding apparatus of claim 7, wherein the first starting code comprises:
a zero code expressed in 32 bits of 0; and
an extension code expressed in 4 bits of 1 and 4 bits of 0.

9. The audio data encoding apparatus of any preceding claim, wherein the SBR encoding unit further comprises a second starting code encoding unit arranged to encode a second starting code that indicates the start of error-detection data that is used to detect an error from the SBR data and the SBR data.

10. The audio data encoding apparatus of claim 9, wherein the second starting code comprises:
a zero code expressed in 32 bits of 0; and
an extension code expressed in 4 bits of 1, a series of 3 bits of 0, and 1.

11. The audio data encoding apparatus of any preceding claim, wherein:
the audio data is given for each of first through M-th (where M denotes an integer equal to or greater than 3) channels; and
the scalable encoding unit comprises:
a mono/stereo encoding unit arranged to encode the audio data of one of the first and second channels; and
a multi-channel extended data encoding unit arranged to encode the audio data of one of the third through M-th channels.

12. The audio data encoding apparatus of claim 11, wherein the multi-channel extended data encoding unit further comprises a third starting code encoding unit arranged to encode a third starting code that indicates the start of the audio data of the third through M-th channels.

13. The audio data encoding apparatus of claim 12, wherein the third starting code comprises:
a zero code expressed in 32 bits of 0; and
an extension code expressed in 8 bits of 1.

14. An audio data decoding apparatus comprising:
a bitstream analysis unit (810) arranged to extract encoded SBR data and encoded audio data corresponding to a plurality of layers, the layer being expressed in predetermined numbers of bits, from a given bitstream;
a scalable decoding unit (820) arranged to decode the encoded audio data by decoding lower layer earlier than upper layer and the upper bit of each layer earlier than the lower bit of each layer;
a SBR decoding unit (830) arranged to decode the encoded SBR data, and inferring audio data in a frequency band between a first predetermined frequency and a second predetermined frequency based on the decoded audio data and the decoded SBR data; and
a data synthesis unit (840) arranged to produce synthetic data by using the decoded audio data and the inferred audio data and to output the synthetic data as the audio data in the frequency band between 0 and the second frequency,
wherein the second predetermined frequency is equal to or greater than the maximum frequency of the layers, and the SBR data comprises information about the audio data in the frequency band between the first and the second frequencies.

15. The audio data decoding apparatus of claim 14, wherein the synthetic data in the frequency band where the decoded audio data exists is the decoded audio data, and the synthetic data in the frequency band where the decoded audio data does not exist is the inferred audio data.

16. The audio data decoding apparatus of claim 14, wherein:
the information about the audio data includes information about the envelope of the audio data;
the SBR decoding unit (830) comprises:
a lossless decoding unit arranged to perform lossless decoding on the encoded SBR data and to obtain the information about the envelope;
a high frequency generation unit arranged to cause the decoded audio data to be generated in a frequency band of frequencies equal to or greater than the maximum frequency of the decoded audio data; and
an envelope adjustment unit arranged to adjust the envelope of the generated audio data based on the obtained information; and
the data synthesis unit outputs the decoded audio data as the synthetic data for the frequency band where the decoded audio data exists, and outputs the envelope-adjusted audio data as the synthetic data for the frequency band where only the envelope-adjusted audio data exists.

17. The audio data decoding apparatus of claim 16, wherein the lossless decoding is entropy decoding or Huffman decoding.

18. The audio data decoding apparatus of any of claims 14 to 17, wherein the decoding of the encoded audio data is executed at or below a predetermined bitrate, and the predetermined bitrate is equal to or greater than the bitrate of the lowest layer.

19. The audio data decoding apparatus of any of claims 14 to 18, wherein the first predetermined frequency is the maximum frequency of the lowest layer.

20. The audio data decoding apparatus of any of claims 14 to 19, wherein:
the bitstream analysis unit (810) is arranged to check if an encoded first starting code exists in the bitstream;
the audio data decoding apparatus further comprises a first starting code decoding unit for decoding the encoded first starting code;
the bitstream analysis unit is arranged to extract the encoded first starting code from the bitstream, if the encoded first starting code exists in the bitstream, and the SBR decoding unit is arranged to operate in response to the result of the checking; and
the first starting code indicates the start of the SBR data.

21. The audio data decoding apparatus of claim 20, wherein the first starting code comprises:
a zero code expressed in 32 bits of 0; and
an extension code expressed in 4 bits of 1 and 4 bits of 0.

22. The audio data decoding apparatus of any of claims 14 to 21, wherein:
the bitstream analysis unit (810) is arranged to check if an encoded second starting code exist in the bitstream;
the audio data decoding apparatus further comprises a second starting code decoding unit for decoding the encoded second starting code;
the bitstream analysis unit is arranged to extract the encoded second starting code from the bitstream, if the encoded second starting code exists in the bitstream, and the SBR decoding unit is arranged to operate in response to the result of the checking; and
the second starting code indicates the start of error-detection data which is used in detecting an error from the SBR data and the SBR data.

23. The audio data decoding apparatus of claim 22, wherein the second starting code comprises:
a zero code expressed in 32 bits of 0; and
an extension code expressed in 4 bits of 1, a series of 3 bits of 0, and 1.

24. The audio data decoding apparatus of any of claims 14 to 23, wherein:
the encoded audio data is given for each of first through M-th (where M denotes an integer equal to or greater than 3) channels; and
the scalable decoding unit comprises:
a mono/stereo decoding unit arranged to decode the encoded audio data of one of the first and second channels; and
a multi-channel extended data decoding unit arranged to decode the encoded audio data of one of the third through M-th channels.

25. The audio data decoding apparatus of claim 24, wherein:
the bitstream analysis unit (810) is arranged to check if an encoded third starting code exists in the bitstream;
the scalable decoding unit further comprises a third starting code decoding unit for decoding the encoded third starting code;
the bitstream analysis unit is arranged to extract the encoded third starting code from the bitstream, if the encoded third starting code exists in the bitstream, and the multi-channel extended data decoding unit is arranged to operate in response to the result of the checking; and
the third starting code indicates the start of the audio data of the third through M-th channels.

26. The audio data decoding apparatus of claim 25, wherein the third starting code comprises:
a zero code expressed in 32 bits of 0; and
an extension code expressed in 8 bits of 1.

27. An audio data encoding method for encoding audio data comprising:
(a) dividing audio data into a plurality of layers, representing the layers of the audio data in predetermined numbers of bits, and coding (1310) the lower layers earlier than the upper layers and the upper bits of each layer earlier than the lower bits thereof;
(b) producing SBR (spectral band replication) data that has information about audio data in a band of frequencies between a first predetermined frequency and a second predetermined frequency among the audio data to be encoded, and encoding (1320) the SBR data; and
(c) producing (1330) a bitstream using the encoded SBR data and the encoded audio data corresponding to a predetermined bitrate;
wherein the second predetermined frequency is equal to or greater than the maximum frequency of the layers, and the SBR data comprises information about the audio data in the frequency band between the first and the second frequencies.

28. The audio data encoding method of claim 27, wherein the first predetermined frequency is the maximum frequency of the lowest layer of the layers of the audio data.

29. The audio data encoding method of claim 27 or 28, wherein (a) comprises producing the SBR data using information about the envelope of the audio data having the frequency band of frequencies equal to or greater than a predetermine frequency and performing lossless encoding on the produced SBR data.

30. The audio data encoding method of claim 29, wherein the lossless encoding is entropy encoding or Huffman encoding.

31. The audio data encoding method of any of claims 27 to 30, wherein (a) comprises down-sampling the audio data and dividing the down-sampled audio data to produced the plurality of layers.

32. The audio data encoding method of any of claims 27 to 31, wherein the predetermined bitrate is equal to or greater than the bitrate of the lowest layer.

33. The audio data encoding method of any of claims 27 to 32, wherein:
the audio data is given for each of first through M-th (where M denotes an integer equal to or greater than 3) channels; and
(a) comprises:
encoding the audio data of one of the first and second channels; and
encoding the audio data of one of the third through M-th channels.

34. An audio data decoding method comprising:
(a) extracting (1410) encoded SBR data and encoded audio data corresponding to plurality of layers the layer being expressed in predetermined numbers of bits, from a given bitstream;
(b) decoding (1420) the encoded audio data by decoding lower layer earlier than upper layer and the upper bit of each layer earlier than the lower bit of each layer;
(c) decoding (1430) the encoded SBR data, and inferring audio data in a frequency band between a first predetermined frequency and a second predetermined frequency based on the decoded audio data and the decoded SBR data; and
(d) producing (1440) synthetic data by using the decoded audio data and the inferred audio data and determining the synthetic data to be the audio data in the frequency band between 0 and the second frequency,
wherein the second predetermined frequency is equal to or greater than the maximum frequency of the layers and the SBR data comprises information about the audio data in the frequency band between the first and the second frequencies.

35. The audio data decoding method of claim 34, wherein the synthetic data in the frequency band where the decoded audio data exists is the decoded audio data, and the synthetic data in the frequency band where the decoded audio data does not exist is the inferred audio data.

36. The audio data decoding method of claim 34 or 35, wherein:
the information about the audio data includes information about the envelope of the audio data;
(c) comprises:
a lossless decoding unit performing lossless decoding on the encoded SBR data and obtaining the information about the envelope;
a high frequency generation unit causing the decoded audio data to be generated in a frequency band of frequencies equal to or greater than the maximum frequency of the decoded audio data; and
an envelope adjustment unit adjusting the envelope of the generated audio data based on the obtained information; and
(d) comprises determining the decoded audio data to be the synthetic data for the frequency band where the decoded audio data exists, and determining the envelope-adjusted audio data to be the synthetic data for the frequency band where only the envelope-adjusted audio data exists.

37. The audio data decoding method of claim 36, wherein the lossless decoding is entropy decoding or Huffman decoding.

38. The audio data decoding method of any of claims 34 to 37, wherein the decoding of the encoded audio data is executed at or below a predetermined bitrate, and the predetermined bitrate is equal to or greater than the bitrate of the lowest layer.

39. The audio data decoding method of any of claims 34 to 38, wherein the first predetermined frequency is the maximum frequency of the lowest layer.

40. The audio data decoding method of any of claims 34 to 39, wherein:
the encoded audio data is given for each of first through M-th (where M denotes an integer equal to or greater than 3) channels; and
(b) comprises:
decoding the encoded audio data of one of the first and second channels; and
decoding the encoded audio data of one of the third through M-th channels.

41. A computer-readable storage medium storing a computer program adapted to perform an audio data encoding method according to any of claims 27 to 33.

42. A computer-readable storage medium storing a computer program adapted to perform an audio data decoding method according to any of claims 34 to 40

## Patentansprüche

1. Audiodatenkodiervorrichtung zum Kodieren von Audiodaten umfassend:
eine skalierbare Kodiereinheit (110), die so ausgebildet ist, dass sie die Audiodaten in eine Mehrzahl von Schichten unterteilt, so dass die Audiodaten in vorgegebenen Anzahlen von Bits in jeder Schicht dargestellt sind, und so dass die untere Schicht früher als die obere Schicht und das obere Bit jeder Schicht früher als das untere Bit darin kodiert wird,
eine SBR-Kodiereinheit (120), die so ausgebildet ist, dass sie SBR(Spektralbandreplikations)-Daten erzeugt, die Informationen über die Audiodaten in einem Frequenzband zwischen einer ersten vorgegebenen Frequenz und einer zweiten vorgegebenen Frequenz der zu kodierenden Audiodaten aufweisen, und die SBR-Daten kodiert, und
eine Bitstrombildungseinheit (130), die so ausgebildet ist, dass sie unter Verwendung der kodierten SBR-Daten und der kodierten Audiodaten entsprechend einer vorgegebenen Bitrate einen Bitstrom erzeugt,
wobei die zweite vorgegebene Frequenz gleich oder größer ist als die maximale Frequenz der Schichten und die SBR-Daten Informationen über die Audiodaten in dem Frequenzband zwischen der ersten und der zweiten Frequenz umfassen.

2. Audiodatenkodiervorrichtung nach Anspruch 1, wobei die erste vorgegebene Frequenz die maximale Frequenz der untersten Schicht der Schichten von Audiodaten ist.

3. Audiodatenkodiervorrichtung nach Anspruch 1 oder 2, wobei die SBR-Kodiereinheit (120) so ausgebildet ist, dass sie die SBR-Daten unter Verwendung von Informationen über die Hülle der Audiodaten mit dem Frequenzband von Frequenzen gleich oder größer als eine vorgegebene Frequenz erzeugt und verlustlose Kodierung der erzeugten SBR-Daten durchführt.

4. Audiodatenkodiervorrichtung nach Anspruch 3, wobei die verlustlose Kodierung eine Entropiekodierung oder eine Huffman-Kodierung ist.

5. Audiodatenkodiervorrichtung nach einem der vorhergehenden Ansprüche, wobei die skalierbare Kodiereinheit (110) so ausgebildet ist, dass sie die Audiodaten downsampelt und die downgesampelten Audiodaten unterteilt, um die Mehrzahl von Schichten zu erzeugen.

6. Audiodatenkodiervorrichtung nach Anspruch 1, wobei die vorgegebene Bitrate gleich oder größer ist als die Bitrate der untersten Schicht.

7. Audiodatenkodiervorrichtung nach einem der vorhergehenden Ansprüche, wobei die SBR-Kodiereinheit (120) ferner eine erste Startkodekodiereinheit umfasst, die so ausgebildet ist, dass sie einen ersten Startkode kodiert, der den Start der SBR-Daten anzeigt.

8. Audiodatenkodiervorrichtung nach Anspruch 7, wobei der erste Startkode umfasst:
einen Nullkode, der in 32 Bits von 0 dargestellt ist, und
einen Extensionskode, der in 4 Bits von 1 und 4 Bits von 0 dargestellt ist.

9. Audiodatenkodiervorrichtung nach einem der vorhergehenden Ansprüche, wobei die SBR-Kodiereinheit ferner eine zweite Startkodekodiereinheit umfasst, die so ausgebildet ist, dass sie einen zweiten Startkode kodiert, der den Start von Fehlererfassungsdaten, die zum Erfassen eines Fehlers bei den SBR-Daten verwendet werden, und der SBR-Daten anzeigt.

10. Audiorlatenkodiervorrichtung nach Anspruch 9, wobei der zweite Startkode umfasst:
einen Nullkode, der in 32 Bits von 0 dargestellt ist, und
einen Extensionskode, der in 4 Bits von 1 und einer Reihe von 3 Bits von 0 und 1 dargestellt ist.

11. Audiodatenkodiervorrichtung nach einem der vorhergehenden Ansprüche, wobei die Audiodaten für jeden eines ersten bis M-ten (wobei M eine ganze Zahl gleich oder größer als 3 bezeichnet) Kanals gegeben sind und
die skalierbare Kodiereinheit umfasst:
eine Mono-/Stereokodiereinheit, die so ausgebildet ist, dass sie die Audiodaten vom ersten oder zweiten Kanal kodiert, und
eine Kodiereinheit für Mehrkanalextensionsdaten, die so ausgebildet ist, dass sie die Audiodaten von einem der dritten bis M-ten Kanäle kodiert.

12. Audiodatenkodiervorrichtung nach Anspruch 11, wobei die Kodiereinheit für Mehrkanalextensionsdaten ferner eine dritte Startkodekodiereinheit umfasst, die so ausgebildet ist, dass sie einen dritten Startkode kodiert, der den Start der Audiodaten des dritten bis M-ten Kanals anzeigt.

13. Audiodatenkodiervorrichtung nach Anspruch 12, wobei der dritte Startkode umfasst:
einen Nullkode, der in 32 Bits von 0 dargestellt ist, und
einen Extensionskode, der in 8 Bits von 1 dargestellt ist.

14. Audiodatendekodiervorrichtung umfassend:
eine Bitstromanalyseeinheit (810), die so ausgebildet ist, dass sie kodierte SBR-Daten und kodierte Audiodaten entsprechend einer Mehrzahl von Schichten, wobei die Schicht in vorgegebenen Anzahlen von Bits dargestellt ist, aus einem vorliegenden Bitstrom extrahiert,
eine skalierbare Dekodiereinheit (820), die so ausgebildet ist, dass sie die kodierten Audiodaten so dekodiert, dass eine untere Schicht früher als eine obere Schicht und das obere Bit in jeder Schicht früher als das untere Bit in jeder Schicht dekodiert wird,
eine SBR-Dekodiereinheit (830), die so ausgebildet ist, dass sie die kodierten SBR-Daten dekodiert und Audiodaten in ein Frequenzband zwischen einem ersten vorgegebenen Frequenzband und einem zweiten vorgegebenen Frequenzband basierend auf den dekodierten Audiodaten und den dekodierten SBR-Daten ableitet, und
eine Datensyntheseeinheit (840), die so ausgebildet ist, dass sie synthetische Daten unter Verwendung der dekodierten Audiodaten und der abgeleiteten Audiodaten bildet und die synthetischen Daten als Audiodaten im Frequenzband zwischen 0 und der zweiten Frequenz ausgibt,
wobei die zweite vorgegebene Frequenz gleich oder größer ist als die maximale Frequenz der Schichten und die SBR-Daten Informationen über die Audiodaten im Frequenzband zwischen der ersten und zweiten Frequenz umfassen.

15. Audiodatendekodiervorrichtung nach Anspruch 14, wobei die synthetischen Daten im Frequenzband, in dem die dekodierten Audiodaten vorliegen, die dekodierten Audiodaten sind und die synthetischen Daten im Frequenzband, in dem die dekodierten Audiodaten nicht vorliegen, die abgeleiteten Audiodaten sind.

16. Audiodatendekodiervorrichtung nach Anspruch 14, wobei:
die Informationen über die Audiodaten Informationen über die Hülle der Audiodaten beinhalten,
die SBR-Dekodiereinheit (830) umfasst:
eine verlustlose Dekodiereinheit, die so ausgebildet ist, dass sie verlustlose Dekodierung bei den kodierten SBR-Daten durchführt und die Informationen über die Hülle ermittelt,
eine Hochfrequenzgeneratoreinheit, die so ausgebildet ist, dass sie ein Erzeugen der dekodierten Audiodaten in einem Frequenzband von Frequenzen gleich oder größer als die maximale Frequenz der dekodierten Audiodaten bewirkt, und
eine Hülleneinstelleinheit, die so ausgebildet ist, dass sie die Hülle der erzeugten Audiodaten basierend auf den ermittelten Informationen einstellt, und
die Datensyntheseeinheit die dekodierten Audiodaten als synthetische Daten für das Frequenzband ausgibt, in dem die dekodierten Audiodaten vorliegen, und die hülleneingestellten Audiodaten als synthetische Daten für das Frequenzband ausgibt, in dem nur die hülleneingestellten Audiodaten vorliegen.

17. Audiodatendekodiervorrichtung nach Anspruch 16, wobei die verlustlose Dekodierung eine Entropiedekodierung oder eine Huffman-Dekodierung ist.

18. Audiodatendekodiervorrichtung nach einem der Ansprüche 14 bis 17, wobei das Dekodieren der kodierten Audiodaten bei oder unter einer vorgegebenen Bitrate vorgenommen wird und die vorgegebene Bitrate gleich oder größer ist als die Bitrate der untersten Schicht.

19. Audiodatendekodiervorrichtung nach einem der Ansprüche 14 bis 18, wobei die erste vorgegebene Frequenz die maximale Frequenz der untersten Schicht ist.

20. Audiodatendekodiervorrichtung nach einem der Ansprüche 14 bis 19, wobei:
die Bitstromanalyseeinheit (810) so ausgebildet ist, dass sie prüft, ob ein kodierter erster Startkode im Bitstrom vorliegt,
die Audiodatendekodiereinheit ferner eine erste Startkodedekodiereinheit zum Dekodieren des kodierten ersten Startkodes umfasst,
die Bitstromanalyseeinheit so ausgebildet ist, dass sie den kodierten ersten Startkode aus dem Bitstrom extrahiert, wenn der kodierte erste Startkode im Bitstrom vorliegt, und die SBR-Dekodiereinheit so ausgebildet ist, dass sie in Abhängigkeit vom Prüfergebnis funktioniert, und
der erste Startkode den Start der SBR-Daten anzeigt.

21. Audiodatendekodiervorrichtung nach Anspruch 20, wobei der erste Startkode umfasst:
einen Nullkode, der in 32 Bits von 0 dargestellt ist, und
einen Extensionskode, der in 4 Bits von 1 und 4 Bits von 0 dargestellt ist.

22. Audiodatendekodiervorrichtung nach einem der Ansprüche 14 bis 21, wobei:
die Bitstromanalyseeinheit (810) so ausgebildet ist, dass sie prüft, ob ein kodierter zweiter Startkode im Bitstrom vorliegt,
die Audiodatendekodiereinheit ferner eine zweite Startkodedekodiereinheit zum Dekodieren des kodierten zweiten Startkodes umfasst,
die Bitstromanalyseeinheit so ausgebildet ist, dass sie den kodierten zweiten Startkode aus dem Bitstrom extrahiert, wenn der kodierte zweite Startkode im Bitstrom vorliegt, und die SBR-Dekodiereinheit so ausgebildet ist, dass sie in Abhängigkeit vom Prüfergebnis funktioniert, und
der zweite Startkode den Start von Fehlererfassungsdaten, die zum Erfassen eines Fehlers bei den SBR-Daten verwendet werden, und der SBR-Daten anzeigt.

23. Audiodatendelkodiervorrichtung nach Anspruch 22, wobei der zweite Startkode umfasst:
einen Nullkode, der in 32 Bits von 0 dargestellt ist, und
einen Extensionskode, der in 4 Bits von 1 und einer Reihe von 3 Bits von 0 und 1 dargestellt ist.

24. Audiodatendekodiervorrichtung nach einem der Ansprüche 14 bis 23, wobei:
die kodierten Audiodaten für jeden eines ersten bis M-ten (wobei M eine ganze Zahl gleich oder größer als 3 bezeichnet) Kanals gegeben werden und
die skalierbare Dekodiereinheit umfasst:
eine Mono-/Stereodekodiereinheit, die so ausgebildet ist, dass sie die kodierten Audiodaten vom ersten oder zweiten Kanal dekodiert, und
eine Dekodiereinheit für Mehrkanalextensionsdaten, die so ausgebildet ist, dass sie die Audiodaten von einem der dritten bis M-ten Kanäle dekodiert.

25. Audiodatendekodiervorrichtung nach Anspruch 24, wobei:
die Bitstromanalyseeinheit (810) so ausgebildet ist, dass sie prüft, ob ein kodierter dritter Startkode im Bitstrom vorliegt,
die skalierbare Dekodiereinheit ferner eine dritte Startkodedekodiereinheit zum Dekodieren des kodierten dritten Startkodes umfasst,
die Bitstromanalyseeinheit so ausgebildet ist, dass sie den kodierten dritten Startkode aus dem Bitstrom extrahiert, wenn der kodierte dritte Startkode im Bitstrom vorliegt, und die Dekodiereinheit für Mehrkanalextensionsdaten so ausgebildet ist, dass sie in Abhängigkeit vom Prüfergebnis funktioniert, und
der dritte Startkode den Start der Audiodaten des dritten bis M-ten Kanals anzeigt.

26. Audiodatendekodiervorrichtung nach Anspruch 25, wobei der dritte Startkode umfasst:
einen Nullkode, der in 32 Bits von 0 dargestellt ist, und
einen Extensionskode, der in 8 Bits von 1 dargestellt ist.

27. Audiodatenkodierverfahren zum Kodieren von Audiodaten umfassend;
(a) Unterteilen von Audiodaten in eine Mehrzahl von Schichten, so dass die Schichten von Audiodaten in vorgegebenen Anzahlen von Bits dargestellt werden, und Kodieren (1310) der unteren Schichten früher als die oberen Schichten und die oberen Bits jeder Schicht früher als die unteren Bits darin,
(b) Erzeugen von SBR(Spektralbandreplikations)-Daten, die Informationen über die Audiodaten in einem Frequenzband zwischen einer ersten vorgegebenen Frequenz und einer zweiten vorgegebenen Frequenz der zu kodierenden Audiodaten aufweisen, und Kodieren (1320) der SBR-Daten und
(c) Erzeugen (1330) eines Bitstroms unter Verwendung der kodierten SBR-Daten und der kodierten Audiodaten entsprechend einer vorgegebenen Bitrate,
wobei die zweite vorgegebene Frequenz gleich oder größer ist als die maximale Frequenz der Schichten und die SBR-Daten Informationen über die Audiodaten in dem Frequenzband zwischen der ersten und der zweiten Frequenz umfassen.

28. Audiodatenkodierverfahren nach Anspruch 27, wobei die erste vorgegebene Frequenz die maximale Frequenz der untersten Schicht der Schichten von Audiodaten ist.

29. Audiodatenkodierverfahren nach Anspruch 27 oder 28, wobei (a) Erzeugen von SBR-Daten unter Verwendung von Informationen über die Hülle der Audiodaten mit dem Frequenzband von Frequenzen gleich oder größer als eine vorgegebene Frequenz und Durchführen einer verlustlosen Kodierung der erzeugten SBR-Daten umfasst.

30. Audiodatenkodierverfahren nach Anspruch 29, wobei die verlustlose Kodierung eine Entropiekodierung oder eine Huffman-Kodierung ist.

31. Audiodatenkodierverfahren nach einem der Ansprüche 27 bis 30, wobei (a) Downsampling der Audiodaten und Unterteilten der downgesampelten Audiodaten zum Ausbilden der Mehrzahl von Schichten umfasst.

32. Audiodatenkodierverfahren nach einem der Ansprüche 27 bis 31, wobei die vorgegebene Bitrate gleich oder größer ist als die Bitrate der untersten Schicht.

33. Audiodatenkodierverfahren nach einem der Ansprüche 27 bis 32, wobei:
die Audiodaten für jeden eines ersten bis M-ten (wobei M eine ganze Zahl gleich oder größer als 3 bezeichnet) Kanals gegeben werden und
(a) umfasst:
Kodieren der Audiodaten vom ersten oder zweiten Kanal und
Kodieren der Audiodaten von einem der dritten bis M-ten Kanäle.

34. Audiodatendekodierverfahren umfassend:
(a) Extrahieren (1410) kodierter SBR-Daten und kodierter Audiodaten entsprechend einer Mehrzahl von Schichten, wobei die Schicht in vorgegebenen Anzahlen von Bits dargestellt ist, aus einem vorliegenden Bitstrom,
(b) Dekodieren (1420) der kodierten Audiodaten durch Dekodieren einer unteren Schicht früher als eine obere Schicht und des oberen Bits jeder Schicht früher als das untere Bit jeder Schicht,
(c) Dekodieren (1430) der kodierten SBR-Daten und Ableiten von Audiodaten in einem Frequenzband zwischen einem ersten vorgegebenen Frequenzband und einem zweiten vorgegebenen Frequenzband basierend auf den dekodierten Audiodaten und den dekodierten SBR-Daten und
(d) Erzeugen (1440) synthetischer Daten unter Verwendung der dekodierten Audiodaten und der abgeleiteten Audiodaten und Bestimmen der synthetischen Daten als die Audiodaten im Frequenzband zwischen 0 und der zweiten Frequenz,
wobei die zweite vorgegebene Frequenz gleich oder größer ist als die maximale Frequenz der Schichten und die SBR-Daten Informationen über die Audiodaten im Frequenzband zwischen der ersten und zweiten Frequenz umfassen.

35. Audiodatendekodierverfahren nach Anspruch 34, wobei die synthetischen Daten im Frequenzband, in dem die dekodierten Audiodaten vorliegen, die dekodierten Audiodaten sind und die synthetischen Daten im Frequenzband, in dem die dekodieren Audiodaten nicht vorliegen, die abgeleiteten Audiodaten sind.

36. Audiodatendekodierverfahren nach Anspruch 34 oder 35, wobei:
die Informationen über die Audiodaten Informationen über die Hülle der Audiodaten beinhalten,
(c) umfasst:
eine verlustlose Dekodiereinheit, die verlustlose Dekodierung bei kodierten SBR-Daten durchführt und die Informationen über die Hülle ermittelt,
eine Hochfrequenzgeneratoreinheit, die ein Erzeugen der dekodierten Audiodaten in einem Frequenzband von Frequenzen gleich oder größer als die maximale Frequenz der dekodierten Audiodaten bewirkt, und
eine Hülleneinstelleinheit, die die Hülle der erzeugten Audiodaten basierend auf den ermittelten Informationen einstellt, und
(d) umfasst:
Bestimmen der dekodierten Audiodaten als synthetische Daten für das Frequenzband, in dem die dekodierten Audiodaten vorliegen, und
Bestimmen der hülleneingestellten Audiodaten als synthetische Daten für das Frequenzband, in dem nur die hülleneingestellten Audiodaten vorliegen.

37. Audiodatendekodierverfahren nach Anspruch 36, wobei die verlustlose Dekodierung eine Entropiedekodierung oder eine Huffman-Dekodierung ist.

38. Audiodatendekodierverfahren nach einem der Ansprüche 34 bis 37, wobei das Dekodieren der kodierten Audiodaten bei oder unter einer vorgegebenen Bitrate vorgenommen wird und die vorgegebene Bitrate gleich oder größer ist als die Bitrate der untersten Schicht.

39. Audiodatendekodierverfahren nach einem der Ansprüche 34 bis 38, wobei die erste vorgegebene Frequenz die maximale Frequenz der untersten Schicht ist.

40. Audiodatendekodierverfahren nach einem der Ansprüche 34 bis 39, wobei die kodierten Audiodaten für jeden eines ersten bis M-ten (wobei M eine ganze Zahl gleich oder größer als 3 bezeichnet) Kanals gegeben werden und
(b) umfasst:
Dekodieren der kodierten Audiodaten des ersten oder zweiten Kanals und
Dekodieren der kodierten Audiodaten von einem der dritten bis M-ten Kanäle.

41. Computerlesbares Speichermedium zum Speichern eines Computerprogramms, das geeignet ist, ein Audiodatenkodierverfahren nach einem der Ansprüche 27 bis 33 auszuführen.

42. Computerlesbares Speichermedium zum Speichern eines Computerprogramms, das geeignet ist, ein Audiodatendekodierverfahren nach einem der Ansprüche 34 bis 40 auszuführen.

## Revendications

1. Appareil de codage de données audio pour coder des données audio comprenant :
une unité de codage extensible (110) agencée pour diviser les données audio en une pluralité de couches, pour représenter les données audio en nombres prédéterminés de bits pour chaque couche, et pour coder la couche inférieure plus tôt que la couche supérieure et le bit supérieur de chaque couche plus tôt que son bit inférieur ;
une unité de codage SBR (120) agencée pour produire des données SBR (reproduction de bande spectrale) qui ont des informations sur les données audio dans une bande de fréquences entre une première fréquence prédéterminée et une seconde fréquence prédéterminée parmi les données audio devant être codées, et pour coder les données SBR ; et
une unité de production de train de bits agencée pour produire un train de bits en utilisant les données SBR codées et les données audio codées correspondant à un débit binaire prédéterminé ;
dans lequel la seconde fréquence prédéterminée est égale ou supérieure à la fréquence maximale des couches, et les données SBR comprennent des informations sur les données audio dans la bande de fréquences entre les première et seconde fréquences.

2. Appareil de codage de données audio selon la revendication 1, dans lequel la première fréquence prédéterminée est la fréquence maximale de la couche la plus basse des couches des données audio.

3. Appareil de codage de données audio selon la revendication 1 ou 2, dans lequel l'unité de codage SBR (120) est agencée pour produire les données SBR en utilisant des informations sur l'enveloppe des données audio ayant la bande de fréquence des fréquences égales ou supérieures à une fréquence prédéterminée et effectue un codage sans perte sur les données SBR produites.

4. Appareil de codage de données audio selon la revendication 3, dans lequel le codage sans perte est un codage entropique ou un codage de Huffman.

5. Appareil de codage de données audio selon l'une quelconque des revendications précédentes, dans lequel l'unité de codage extensible (110) est agencée pour sous-échantillonner les données audio et pour diviser les données audio sous-échantillonnées pour produire la pluralité de couches.

6. Appareil de codage de données audio selon la revendication 1, dans lequel le débit binaire prédéterminé est égal ou supérieur au débit binaire de la couche la plus basse.

7. Appareil de codage de données audio selon l'une quelconque des revendications précédentes, dans lequel l'unité de codage SBR (120) comprend en outre une unité de codage de premier code de début agencée pour coder un premier code de début qui indique le début des données SBR.

8. Appareil de codage de données audio selon la revendication 7, dans lequel le premier code de début comprend :
un code de zéros exprimé en 32 bits de 0 ; et
un code d'extension exprimé en 4 bits de 1 et 4 bits de 0.

9. Appareil de codage de données audio selon l'une quelconque des revendications précédentes, dans lequel l'unité de codage SBR comprend en outre une unité de codage de second code de début agencée pour coder un second code de début qui indique le début de données de détection d'erreur qui sont utilisées pour détecter une erreur parmi les données SBR et des données SBR.

10. Appareil de codage de données audio selon la revendication 9, dans lequel le second code de début comprend :
un code de zéros exprimé en 32 bits de 0 ; et
un code d'extension exprimé en 4 bits de 1, une série de 3 bits de 0, et un 1.

11. Appareil de codage de données audio selon l'une quelconque des revendications précédentes, dans lequel :
les données audio sont données pour chacune de première à M-ième voies (où M indique un entier égal ou supérieur à 3) ; et
l'unité de codage dimensionnable comprend :
une unité de codage mono/stéréo agencée pour coder les données audio de l'une des première et seconde voies ; et
une unité de codage de données étendues multivoies agencée pour coder les donnée audio de l'une des troisième à M-ième voies.

12. Appareil de codage de données audio selon la revendication 11, dans lequel l'unité de codage de données étendues multivoies comprend en outre une unité de codage de troisième code de début agencée pour coder un troisième code de début qui indique le début des données audio des troisième à M-ième voies.

13. Appareil de codage de données audio selon la revendication 12, dans lequel le troisième code de début comprend :
un code de zéros exprimé en 32 bits de 0 ; et
un code d'extension exprimé en 8 bits de 1.

14. Appareil de décodage de données audio comprenant :
une unité d'analyse de train de bits (810) agencée pour extraire les données SBR codées et les données audio codées correspondant à une pluralité de couches, la couche étant exprimée en nombres prédéterminés de bits, d'un train de bits donné ;
une unité de décodage extensible (820) agencée pour décoder les données audio codées en décodant la couche inférieure plus tôt que la couche supérieure et le bit supérieur de chaque couche plus tôt que le bit inférieur de chaque couche ;
une unité de décodage SBR (830) agencée pour décoder les données SBR codées, et inférer des données audio dans une bande de fréquences entre une première fréquence prédéterminée et une seconde fréquence prédéterminée sur la base des données audio décodées et des données SBR décodées ; et
une unité de synthèse de données (840) agencée pour produire des données synthétique en utilisant les données audio décodées et les données audio inférées et pour sortir les données synthétiques sous forme de données audio dans la bande de fréquences entre 0 et la seconde fréquence,
dans lequel la seconde fréquence prédéterminée est égale ou supérieure à la fréquence maximale des couches, et les données SBR comprennent des informations sur les données audio dans la bande de fréquences entre les première et seconde fréquences.

15. Appareil de décodage de données audio selon la revendication 14, dans lequel les données synthétiques dans la bande de fréquences où les données audio décodées existent sont les données audio décodées, et les données synthétiques dans la bande de fréquences où les données audio décodées n'existent pas sont les données audio inférées.

16. Appareil de décodage de données audio selon la revendication 14, dans lequel :
les informations sur les données audio comprennent des informations sur l'enveloppe des données audio ;
l'unité de décodage SBR (830) comprend :
une unité de décodage sans perte agencée pour effectuer un décodage sans perte sur les données SBR codées et pour obtenir les informations sur l'enveloppe ;
une unité de génération de hautes fréquences agencée pour faire que les données audio décodées soient générées dans une bande de fréquences de fréquences égales ou supérieures à la fréquence maximale des données audio décodées ; et
une unité d'ajustement d'enveloppe agencée pour ajuster l'enveloppe des données audio générées sur la base des informations obtenues ; et
l'unité de synthèse de données sort les données audio décodées sous la forme des données synthétiques pour la bande de fréquences où les données audio décodées existent, et sort les données audio ajustées en enveloppe sous la forme des données synthétiques pour la bande de fréquences où seules les données audio ajustées en enveloppe existent.

17. Appareil de décodage de données audio selon la revendication 16, dans lequel le décodage sans perte est un décodage entropique ou un décodage de Huffman.

18. Appareil de décodage de données audio selon l'une quelconque des revendications 14 à 17, dans lequel le décodage des données audio codées est exécuté à, ou en dessous d'un débit binaire prédéterminés, et le débit binaire prédéterminé est égal ou supérieur au débit binaire de la couche la plus basse.

19. Appareil de décodage de données audio selon l'une quelconque des revendications 14 à 18, dans lequel la première fréquence prédéterminée est la fréquence maximale de la couche la plus basse.

20. Appareil de décodage de données audio selon l'une quelconque des revendications 14 à 19, dans lequel :
l'unité d'analyse de train de bits (810) est agencée pour vérifier si un premier code de début codé existe dans le train de bits ;
l'appareil de décodage de données audio comprend en outre une unité de décodage de premier code de début pour décoder le premier code de début codé ;
l'unité d'analyse de train de bits est agencée pour extraire le premier code de début codé du train de bits, si le premier code de début codé existe dans le train de bits, et l'unité de décodage SBR est agencée pour opérer en réponse au résultat de la vérification ; et
le premier code de début indique le début des données SBR.

21. Appareil de décodage de données audio selon la revendication 20, dans lequel le premier code de début comprend :
un code de zéros exprimé en 32 bits de 0 ; et
un code d'extension exprimé en 4 bits de 1 et 4 bits de 0.

22. Appareil de décodage de données audio selon l'une quelconque des revendications 14 à 21, dans lequel :
l'unité d'analyse de train de bits (810) est agencée pour vérifier si un second code de début codé existe dans le train de bits ;
l'appareil de décodage de données audio comprend en outre une unité de décodage de second code de début pour décoder le second code de début codé ;
l'unité d'analyse de train de bits est agencée pour extraire le second code de début codé du train de bits, si le second code de début codé existe dans le train de bits, et l'unité de décodage SBR est agencée pour opérer en réponse au résultat de la vérification ; et
le second code de début indique le début des données de détection d'erreur qui sont utilisées dans la détection d'une erreur parmi les données SBR et des données SBR.

23. Appareil de décodage de données audio selon la revendication 22, dans lequel le second code de début comprend :
un code de zéros exprimé en 32 bits de 0 ; et
un code d'extension exprimé en 4 bits de 1, une série de 3 bits de 0, et un 1.

24. Appareil de décodage de données audio selon l'une quelconque des revendications 14 à 23, dans lequel :
les données audio codées sont données pour chacune de première à M-ième voies (où M indique un entier égal ou supérieur à 3) ; et
l'unité de décodage extensible comprend :
une unité de décodage mono/stéréo agencée pour décoder les données audio codées de l'une des première et seconde voies ; et
une unité de décodage de données étendues multivoies agencée pour décoder les données audio codées de l'une des troisième à M-ième voies.

25. Appareil de décodage de données audio selon la revendication 24, dans lequel :
l'unité d'analyse de train de bits (810) est agencée pour vérifier si un troisième code de début codé existe dans le train de bits ;
l'unité de décodage extensible comprend en outre une unité de décodage de troisième code de début pour décoder le troisième code de début codé ;
l'unité d'analyse de train de bits est agencée pour extraire le troisième code de début codé du train de bits, si le troisième code de début codé existe dans le train de bits, et l'unité de décodage de données étendues multivoies est agencée pour opérer en réponse au résultat de la vérification ; et
le troisième code de début indique le début des données audio des troisième à M-ième voies.

26. Appareil de décodage de données audio selon la revendication 25, dans lequel le troisième code de début comprend :
un code de zéros exprimé en 32 bits de 0 ; et
un code d'extension exprimé en 8 bits de 1.

27. Procédé de codage de données audio pour coder des données audio comprenant les étapes consistant à :
(a) diviser des données audio en une pluralité de couches, représenter les couches des données audio en nombres prédéterminés de bits, et coder (1310) les couches inférieures plus tôt que les couches supérieures et les bits supérieurs de chaque couche plus tôt que ses bits inférieurs ;
(b) produire des données SBR (reproduction de bande spectrale) qui ont des informations sur les données audio dans une bande de fréquences entre une première fréquence prédéterminée et une seconde fréquence prédéterminée parmi les données audio devant être codées, et coder (1320) les données SBR ; et
(c) produire (1330) un train de bits en utilisant les données SBR codées et les données audio codées correspondant à un débit binaire prédéterminée ;
dans lequel la seconde fréquence prédéterminée est égale ou supérieure à la fréquence maximale des couches, et les données SBR comprennent des informations sur les données audio dans la bande de fréquences entre les première et seconde fréquences.

28. Procédé de codage de données audio selon la revendication 27, dans lequel la première fréquence prédéterminée est la fréquence maximale de la couche la plus basse des couches des données audio.

29. Procédé de codage de données audio selon la revendication 27 ou 28, dans lequel (a) comprend la production des données SBR en utilisant des informations sur l'enveloppe des données audio ayant la bande de fréquences des fréquences égales ou supérieures à une fréquence prédéterminée et l'exécution d'un codage sans perte sur les données SBR produites.

30. Procédé de codage de données audio selon la revendication 29, dans lequel le codage sans perte est un codage entropique ou un codage de Huffman.

31. Procédé de codage de données audio selon l'une quelconque des revendications 27 à 30, dans lequel (a) comprend le sous-échantillonnage des données audio et la division des données audio sous-échantillonnées pour produire la pluralité de couches.

32. Procédé de codage de données audio selon les revendications 27 à 31, dans lequel le débit binaire prédéterminé est égal ou supérieur au débit binaire de la couche la plus basse.

33. Procédé de codage de données audio selon l'une quelconque des revendications 27 à 32, dans lequel :
les données audio sont données pour chacune de première à M-ième voies (où M indique un entier égal ou supérieur à 3) ; et
(a) comprend :
le codage des données audio de l'une des première et seconde voies ; et
le codage des données audio de l'une des troisième à M-ième voies.

34. Procédé de décodage de données audio comprenant les étapes consistant à :
(a) extraire (1410) des données SBR codées et des données audio codées correspondant à une pluralité de couches, les couches étant exprimées en nombres prédéterminés de bits, d'un train de bits donné ;
(b) décoder (1420) les données audio codées en décodant la couche inférieure plus tôt que la couche supérieure et le bit supérieur de chaque couche plus tôt que le bit inférieur de chaque couche ;
(c) décoder (1430) les données SBR codées et inférer des données audio dans une bande de fréquences entre une première fréquence prédéterminée et une seconde fréquence prédéterminée sur la base des données audio décodées et des données SBR décodées ; et
(d) produire (1440) des données synthétiques en utilisant les données audio décodées et les données audio inférées et déterminer les données synthétiques devant être les données audio dans la bande de fréquences entre 0 et la seconde fréquence,
dans lequel la seconde fréquence prédéterminée est égale ou supérieure à la fréquence maximale de la pluralité de couches et les données SBR comprennent des informations sur les données audio dans la bande de fréquence entre les première et seconde fréquences.

35. Procédé de décodage de données audio selon la revendication 34, dans lequel les données synthétiques dans la bande de fréquences où les données audio décodées existent sont les données audio décodées, et les données synthétiques dans la bande de fréquences où les données audio décodées n'existent pas sont les données audio inférées.

36. Procédé de décodage de données audio selon la revendication 34 ou 35, dans lequel :
les informations sur les données audio comprennent des informations sur l'enveloppe des données audio ;
(c) comprend :
une unité de décodage sans perte effectuant un décodage sans perte sur les données SBR codées et obtenant les informations sur l'enveloppe ;
une unité de génération de hautes fréquences faisant en sorte que les données audio décodées soient générées dans une bande de fréquences de fréquences égales ou supérieures à la fréquence maximale des données audio décodées ; et
une unité d'ajustement d'enveloppe ajustant l'enveloppe des données audio générées sur la base des informations obtenues ; et
(d) comprend la détermination des données audio décodées devant être les données synthétiques pour la bande de fréquences où les données audio décodées existent, et la détermination des données audio ajustées en enveloppe devant être les données synthétiques pour la bande de fréquences où seules les données audio ajustées en enveloppe existent.

37. Procédé de décodage de données audio selon la revendication 36, dans lequel le décodage sans perte est un décodage entropique ou un décodage de Huffman.

38. Procédé de décodage de données audio selon l'une quelconque des revendications 34 à 37, dans lequel le décodage des données audio codées est exécuté à, ou en dessous d'un débit binaire prédéterminé, et le débit binaire prédéterminé est égal ou supérieur au débit binaire de la couche la plus basse.

39. Procédé de décodage de données audio selon l'une quelconque des revendications 34 à 38, dans lequel la première fréquence prédéterminée est la fréquence maximale de la couche la plus basse.

40. Procédé de décodage de données audio selon l'une quelconque des revendications 34 à 39, dans lequel :
les données audio codées sont données pour chacune de première à M-ième voies (où M indique un entier égal ou supérieur à 3) ; et
(b) comprend :
le décodage des données audio codées de l'une des première et seconde voies ; et
le décodage des données audio codées de l'une des troisième à M-ième voies.

41. Support de stockage lisible par ordinateur stockant un programme informatique adapté pour exécuter un procédé de codage de données audio selon l'une quelconque des revendications 27 à 33.

42. Support de stockage lisible par ordinateur stockant un programme informatique adapté pour exécuter un procédé de décodage de données audio selon l'une quelconque des revendications 34 à 40.
